(19) **Europäisches Patentamt**

**European Patent Office**

**Office européen des brevets**

(11) **EP 1 172 905 A1**

(12) **EUROPEAN PATENT APPLICATION**

(43) Date of publication:
**16.01.2002 Bulletin 2002/03**

(51) Int Cl.⁷: **H01S 5/0625**, H01S 5/0683

(21) Application number: **01870155.7**

(22) Date of filing: **06.07.2001**

| | |
|---|---|
| (84) Designated Contracting States:<br>**AT BE CH CY DE DK ES FI FR GB GR IE IT LI LU MC NL PT SE TR**<br>Designated Extension States:<br>**AL LT LV MK RO SI** | • **Universiteit Gent**<br>**9000 Gent (BE)** |
| (30) Priority: **11.07.2000 US 217296**<br>**12.01.2001 EP 01870006** | (72) Inventor: **Morthier, Geert**<br>**9031 Gent (BE)** |
| (71) Applicants:<br>• **INTERUNIVERSITAIR MICROELEKTRONICA CENTRUM VZW**<br>**3001 Leuven (BE)** | (74) Representative: **Van Malderen, Joelle et al**<br>**Office Van Malderen, Place Reine Fabiola 6/1**<br>**1083 Bruxelles (BE)** |

(54) **A method and apparatus for controlling a laser structure**

(57) The present invention is related to a method for controlling a laser structure, comprising at least an amplifying section (10), a phase section (20), a first reflection section (30), a first facet (40), emitting a substantial part of the electromagnetic radiation generated by said laser structure, and a second facet (50), injection means (60) for injecting current in said phase section, injection means (70) for injecting current in said reflection section, said method comprising the steps of:

- determining a first value by measuring the power output at said first facet (40),
- determining a second value by measuring the power output at said second facet (50),
- determining a third value depending on said first value and said second value
- determining a plurality of values for currents for controlling said laser structure from at least said third value, wherein said determining being based on a step of optimising said third value,
- injecting said currents with said determined current values via said injection means.

FIG. 1

**Description**

**Field of the invention**

The invention relates to multi-section integrated semiconducting devices or lasers, more in particular, methods for obtaining a stable operation of such devices or lasers, as well as to devices for the implementation of said methods.

**State of the art**

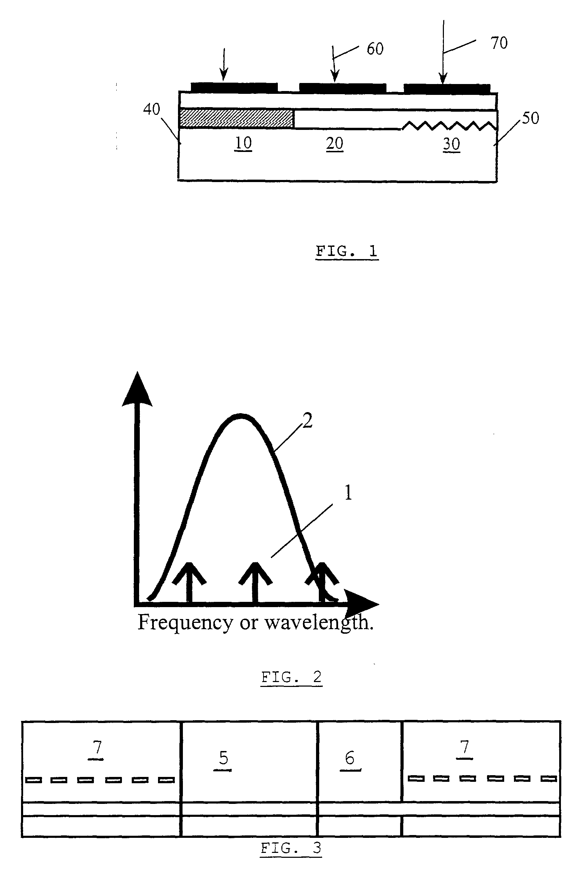

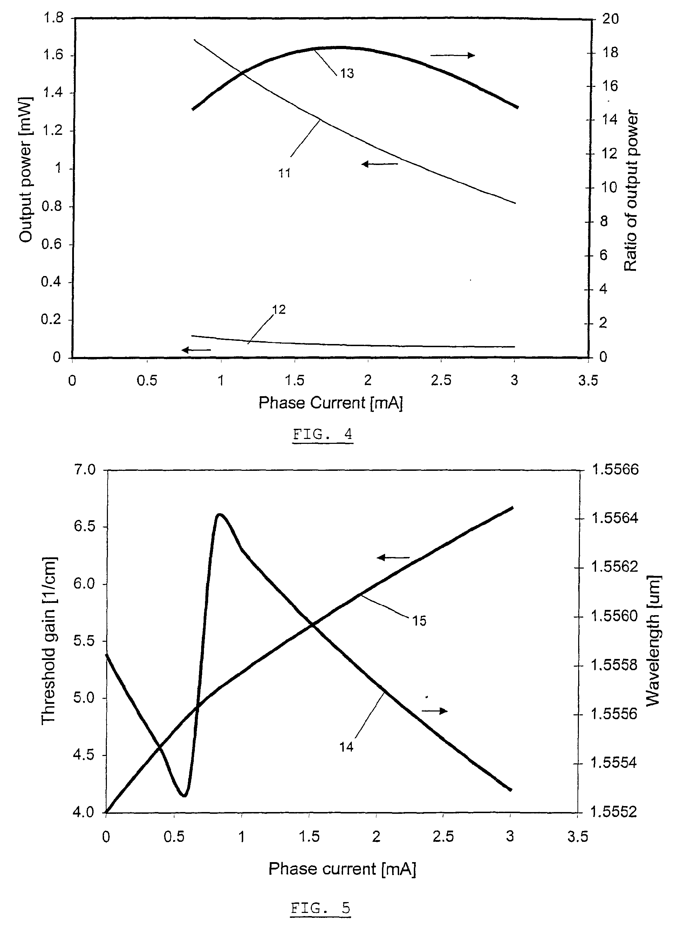

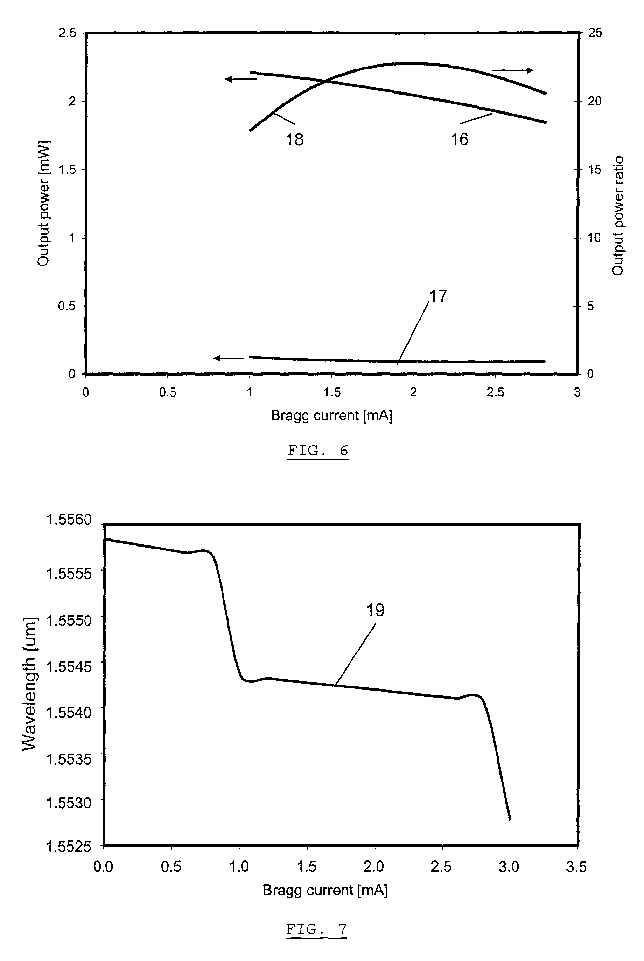

Distributed Bragg Reflector (DBR) laser diodes are laser diodes, which generally consist of 3 sections and which are wavelength tuneable and can therefore play an important role as sources in WDM communication. The typical structure of a DBR laser diode is shown schematically in Figure 1. Of the 3 sections, a first section 10 serves as an amplifying or gain providing section and the current in this section can be used to adjust the output power (emitted through the front facet e.g.). The last section 30 (the reflection section or Bragg section) is passive and contains a grating and therefore gives a frequency dependent reflection. The current injected into this section allows to shift the reflection spectrum typically over several nm in wavelength. Figure 2 shows such a spectrum, with the cavity modes 1 and the reflection from the Bragg section 2. The middle section 30 is a passive section that just gives a phase shift and which can be used to shift the phase resonances or longitudinal modes of the cavity (by adjusting the current into this section).

A stable operation of such a DBR laser diode is obtained when the cavity mode coincides with the peak reflection from the Bragg section 30. The tuning has to occur by changing phase and Bragg current such that both the wavelength of the peak reflection and the cavity mode wavelength coincide with the desired wavelength. Before such a laser diode can be used in real systems, one has to make sure that it is sufficiently stable and external control has to be provided to guarantee this. 'Sufficiently stable' means that the output power and the wavelength have to remain constant over time and that also a high side mode rejection has to be guaranteed.

As for the power stability, it is known since long that this can be achieved by splitting of a part of the output power (from the front facet), feeding it to a monitor photodiode and using the generated photo current as feedback for the active section current. To control the wavelength and the side mode rejection is a bit more difficult. A few methods have been developed recently which make use of a wavelength locker and either the output power (from the front facet) or the voltage over the active region. In these methods, one modulates the current for the Bragg section slightly and adjusts the bias current for the Bragg section until a minimum in active section voltage modulation or a maximum in output power modulation is obtained. This guarantees single mode operation. The phase current is then adjusted based on a signal from the wavelength locker (typically based on a periodic optical filter) until the right wavelength is obtained.

Both methods however only work well if the losses in the Bragg section do not increase too much with injected current. Such a loss increase with increasing current is due to free carrier absorption for instance and will occur often in practice. As a result, the above mentioned control methods can not always be applied.

The same observation can be made for (S)SG-DBR laser diodes, which are laser diodes which generally consist of 4 sections and which are wavelength tuneable and can therefore play an important role as sources in WDM communication. The typical structure of a (S)SG-DBR laser diode is shown schematically in Figure 3. Of the 4 sections, the 2nd section 5 serves as an amplifying or gain providing section and the current in this section can be used to adjust the output power (emitted through the front facet e.g.). The first and last section 7 are passive and contain a sampled or superstructure grating and therefore give, as a function of wavelength, a comb of reflection peaks. The peak separation is different for both gratings though and it depends on the current in each (S)SG section whether and which peaks will overlap. The current injected into these sections allows to shift the reflection spectra typically over several nm in wavelength. The 3rd section 6 is a passive section that just gives a phase shift and which can be used to shift the phase resonances or longitudinal modes of the cavity (by adjusting the current into this section). To obtain a stable operation of such an (S)SG-DBR laser diode, it is desired to have a cavity mode coinciding with a peak in the reflection spectra from both the Bragg sections 7. The tuning has to occur by changing phase and Bragg currents such that a peak of the reflection spectra from both grating sections 7 coincides with the desired wavelength and such that the cavity mode wavelength coincides with the desired wavelength.

Prior-art control methods exploit feedback of a single measurable quantity of the laser, such as the output power through the front facet, the wavelength of the outputted electromagnetic radiation or the modulation of the voltage across the active section due to modulation of the current in the reflection section. One of said single measurable quantities is then used for determining the current to be injected in said reflection section. Said prior-art control methods are not applicable when the losses in the reflection section increase too much with injected current. Whether this appears is dependent on the laser structure itself. For laser structure with such loss effect, no suitable prior-art control method is known.

Document JP-A-11087827 describes a device wherein the intensity of the backward output light is measured, and used for controlling the injection current to the DBR region. This single intensity measurement is not independent of loss increases in the DBR section.

The same is true for the device described in document JP-A-63160391, wherein two Bragg reflectors are controlled by output difference signals of two photodetectors, measuring signals at one end of the device, after a Y-shaped multipoint type waveguide.

In document US-A-5450428, a device is proposed wherein feedback control is conducted in a manner such that the ratio of a forward-directed optical output and a backward-directed optical output from a frequency-variable light source is fixed to a predetermined value.

### Aims of the invention

The present invention aims to provide a method for controlling laser structures and an apparatus for implementing such control method which are applicable also to laser structures showing a substantial increase of the losses in at least one of its sections when increasing the current in said section.

### Summary of the invention

In a first aspect of the invention a method for controlling a laser structure is disclosed.

With a laser structure is meant a semiconductor substrate having at least an amplifying or active section , a phase section, a reflection section, a first facet and a second facet. Said active section is generating radiation, for instance but not limited to the range of optical radiation. Said first facet, also denoted front facet, is distinguished from said second facet, by the fact that it emits a substantial part of the electromagnetic radiation generated by said laser structure, in normal operation of said laser.

The laser structure meant can be a Distributed Bragg Reflector (DBR) semiconductor laser but is not limited thereto. It must be particularly emphasised that the disclosed control method is also suited for laser structures with a plurality of reflection sections such as so-called Sampled Grating (SG) DBR lasers, superstructure-grating (SSG) DBR lasers, Grating Coupler Sampled Reflector (GCSR) laser and the structures disclosed in Patent Applications EP 998701056 and EP 998702146.

With controlling is meant determining inputs for a structure such that said structure has a desired behaviour. Controlling a laser structure requires tuneability of said structure and thus tuneability of at least some of the sections of said laser structure. With tuneability is meant that the characteristic of the section is modifiable. The characteristic of a section is modifiable or changeable by changing the current injected in (part of) said section or equivalently by changing the voltage across such a section. Said current injected or said voltage across said section can be considered as input parameters of said laser structure. A laser device comprises means for injecting current into part of sections or means for applying a voltage across part of sections. The characteristic of a section can be either a transmission, reflection or phase characteristic as function of the wavelength depending on the type of section. Changing injection currents or voltages results in shifting of said characteristics in wavelength.

The desired behaviour of a laser structure is that it has a stable operation, meaning that the output power and the wavelength of the electromagnetic radiation is sufficiently constant over a long time period. Said desired behaviour is guaranteed by using external control systems for implementing a control method, for instance the one disclosed here.

It is a characteristic of the control method that determining of at least one of the currents exploited for controlling said laser structure is not based on a single measurable quantity or value but on a combination of measurable quantities or values, more particularly on an optimisation of said combination of measurable quantities or values.

It is a further characteristic of the invented control method that said combination of measurable quantities, thus being another quantity, is chosen such that said quantity is independent of the loss increases (due to current injection) in the section, used for controlling the laser structure. Alternatively it can be stated that said quantity is independent of the loss variations due to variations in the injected current. This property of the disclosed control method results in the fact that said method can be applied to any type of laser structures, independently of whether it shows a large increase of the losses in its section, used for control, as a function of the injected current.

In a first embodiment of the method of the invention, the measurable quantities to be combined are two values based on a measurement of the two power outputs, respectively measured at said first facet and said second facet. Said combination is then a third value, derived from the previous two values. At least one current is then derived from a step of optimising said third value, after which said current is injected.

Preferably, the combination of both values is the ratio of said values, in the most preferred case the ratio of the output powers themselves. Said combination may equally be the ratio of a function of said first value to a function of said second value.

In a second embodiment of the invention said measurable quantities are combined such that the resulting quantity is independent or at least substantially independent of the loss increases in the section, used for controlling the laser structure. This independence or substantial independence can be obtained when said quantity is independent or substantially independent of the losses itself, although the invention is not limited to such quantities.

In a third embodiment of the invention said third value is optimised for controlling the current in the phase section while the current injected in the reflection section is used for feedback control of the wavelength.

In a fourth embodiment of the invention said third value is optimised for controlling the current in the reflection section while the current injected in the phase section is used for feedback control of the wavelength.

In a second aspect of the invention an apparatus suited for controlling of laser structures is presented.

## Brief description of the drawings

Figure 1 describes a classical DBR laser.

Figure 2 shows the frequency characteristic of the Bragg section and the phase section of the laser of Figure 1.

Figure 3 describes a 4-section DBR laser.

Figure 4 shows numerical simulations, illustrating that the power output ratio shows a maximum as function of the phase section current, although the individual measurable power outputs show no such minimum. Note that said power output ratio is theoretically shown to have no dependence on the losses in said phase section.

Figure 5 shows further numerical simulations, illustrating the wavelength and threshold gain of the laser structure, being controlled by the disclosed control method.

Figure 6 shows other numerical simulations, illustrating that the power output ratio can show a maximum as function of the reflection section current, although the individual measurable power outputs show no such minimum.

Figure 7 shows a further numerical simulation, illustrating the wavelength of the laser structure, as a function of the reflection section current.

Figure 8 shows output powers and their ratio vs. phase current for perfect overlap between the peak wavelengths of the reflection from both gratings.

Figure 9 shows output powers and their ration vs. phase current for a difference of 0.5 nm in peak wavelength between the reflections from both grating sections.

## Detailed description of the invention

Prior-art control methods exploit feedback of a single measurable quantity of the laser, such as the output power through the front facet, the wavelength of the outputted electromagnetic radiation or the modulation of the voltage across the active section due to modulation of the current in the reflection section. One of said single measurable quantities is then used for determining the current to be injected in said reflection section. Said prior-art control methods are not applicable when the losses in the reflection section increase too much with injected current. Whether or not this happens is dependent on the laser structure itself. For laser structures with such a loss effect, no suitable prior-art control method is known.

It is to be noted that substantial increases of the losses in the section used for control of the laser structure, due to increasing the current injected in said section is the main technical problem that prior-art control methods have.

What follows is a theoretical explanation leading to the invented control scheme. Although said explanation is valid for DBR laser diodes, the invented control method is not limited hereto.

Figure 1 shows a schematic drawing of a laser structure with an amplifying section 10, a phase section 20, a reflection section 30, a first facet 40, a second facet 50, injection means 60 attached to said phase section and injection means 70 attached to said reflection section, which can be controlled by the invented control method, although said control method is clearly not limited to such structure only.

A 3 section DBR laser diode of Figure 1 can be considered as a Fabry-Perot laser with a constant facet reflectivity, further denoted $R_1$ on one side and a wavelength dependent facet reflectivity $R_2$, determined by the phase section 20 and the Bragg section 30 on the other side. The transmission through the facet 40 with constant reflectivity is given by $1-R_1$, but the transmission through phase and Bragg sections, which are generally lossy, is not given by $1-R_2$ and called $T_2$. Consider a Fabry-Perot laser with facet reflection $R_1$ on the l.h.s. (left hand side) and facet reflection $R_2$ on the r.h.s. (right hand side) and with a net gain (amplification) of g (g in cm$^{-1}$). If $P_f(0)$ is the forward propagating power at z=0 (left facet), then the forward propagating power at z=L (right facet) is given by $P_f(L) = P_f(0) \exp(gL)$. After reflection at R2, one finds for the backward propagating power $P_b(L)$, $P_b(L) = R_2 P_f(L)$. After propagation over a distance L (this time in the backward direction), one finds $P_b(0)=P_b(L) \exp(gL)$. After reflection at z=0, one finds $P_f(0)=R_1 P_b(0)$. I.e. if there is lasing, we must find the original field after one roundtrip in the laser cavity. This is the oscillation condition which reduces to $R_1 R_2 \exp(2gL)=1$ or $\exp(gL) =1/\mathrm{Sqrt}(R_1 R_2)$. The output power from the r.h.s. facet is given by $P_f(L) T_2 = \exp(gL)T_2 P_f(0)$. The output power from the l.h.s. facet is given by $P_b(0)T_1 = [P_f(0)/R_1 T_1]$. The ratio of both output powers is hence $\exp(gL)R_1T_2/T_1 = Sqrt(R_1/R_2)T_2/T_1$.

Using these definitions and the simple theory of a Fabry-Perot laser, one can express the ratio of the output powers from both facets as follows:

$$\frac{S_{out,R}}{S_{out,L}} = \frac{T_2}{1-R_1}\sqrt{\frac{R_1}{R_2}}$$

with $S_{out,R}$ the power from the right hand facet and $S_{out,L}$ the power from the left hand facet. Assuming no discrete reflections between phase 20 and Bragg section 30 or between gain 10 and phase section 20, this can be further simplified. Indeed, with $R_3$ the wavelength dependent reflection from the Bragg section and $T_3$ the transmission from the Bragg section, one can write:

$$R_2 = R_3 \exp\left[-2\int_0^{L_p}\alpha_p(z,I_p)dz\right] \quad \text{and} \quad T_2 = T_3 \exp\left[-\int_0^{L_p}\alpha_p(z,I_p)dz\right]$$

with $\alpha_p(z,I_p)$ the absorption in the phase section, which in the most general case can depend on the location and on the current in the phase section. With the new expressions for $R_2$ and $T_2$ it is however easily seen that the ratio of the output powers becomes :

$$\frac{S_{out,R}}{S_{out,L}} = \frac{T_3}{1-R_1}\sqrt{\frac{R_1}{R_3}}$$

Hence this ratio is independent of the losses in the phase section, so that it is a quantity suitable for controlling laser structures for which prior-art control method would fail.

There will be a minimum in the ratio of the output powers if the wavelength coincides with the Bragg wavelength. This will be the case as long as the wavelength dependent functions $T_3$ and $R_3$ remain unchanged, i.e. as long as the Bragg current is constant. In this case $R_3$ becomes maximum and $T_3$ minimum at the Bragg wavelength. To get this situation, one can change the phase current (which changes the wavelength) until minimum output power ratio is obtained. This optimisation of the ratio of the output powers forms the main characteristic aspect of the method of the invention. Note that due to the particular selection of this ratio as the quantity for control, the loss changes in the phase section due to current injection, being the input parameter for control, do not affect the control of the laser structure.

This control of the phase current ensures that the phase resonance overlaps with the maximum reflection from the Bragg section 30 and hence it ensures high side mode rejection ratio. To control the value of the wavelength itself one can then change the Bragg current, injected by injection means 70.

Some numerical calculations of a 3 section DBR lasers with carrier density dependent losses in the phase and Bragg sections show that the disclosed control method works. In a number of examples, a clear maximum in the ratio of the output powers was obtained as a function of the phase current, while no optimum in either output power or in the voltage was seen. Figure 4 shows both the output powers on left and right side (11, 12) and their ratio 13 as a function of the phase current for a particular example. The corresponding variation of wavelength 14 and threshold gain 15 is shown in Figure 5.

Above a quantity is derived which is at least theoretically independent of the losses of the section used for control of the laser structure via the current injected in said section. The fact that said derived quantity is independent of the losses implies that it is independent of the loss increases due to increasing the current in the related section also, and hence it is an excellent quantity for controlling the laser structure.

Naturally said quantity must not be completely independent of said losses nor must it be completely independent of the loss increases due to increasing the current in the related section. It is sufficient that said quantity is substantially independent of the loss increases due to the increasing current.

By controlling the current in a section of a laser structure one shifts its frequency characteristic in wavelength. When selecting one single quantity used for control, e.g. the output power of the front facet, one will observe a maximum for said output power when the maximum of said frequency characteristic overlaps with the frequency characteristic of the other sections of said laser. In a DBR laser one controls the Bragg or reflection section 30 via the current injected in said Bragg section and shifts its characteristic until it matches the phase section characteristic. However, due to the increase of losses in the reflection section, one can not guarantee that by just shifting the frequency characteristic, an optimal value of the control quantity will be observed.

The quantity to be used for control is considered to be substantially independent of the loss increases due to the increasing current when there is still an optimum observed by changing the current of the section, used for control. An optimum will be observed when the effect of overlapping or matching frequency characteristics dominates the loss effects.

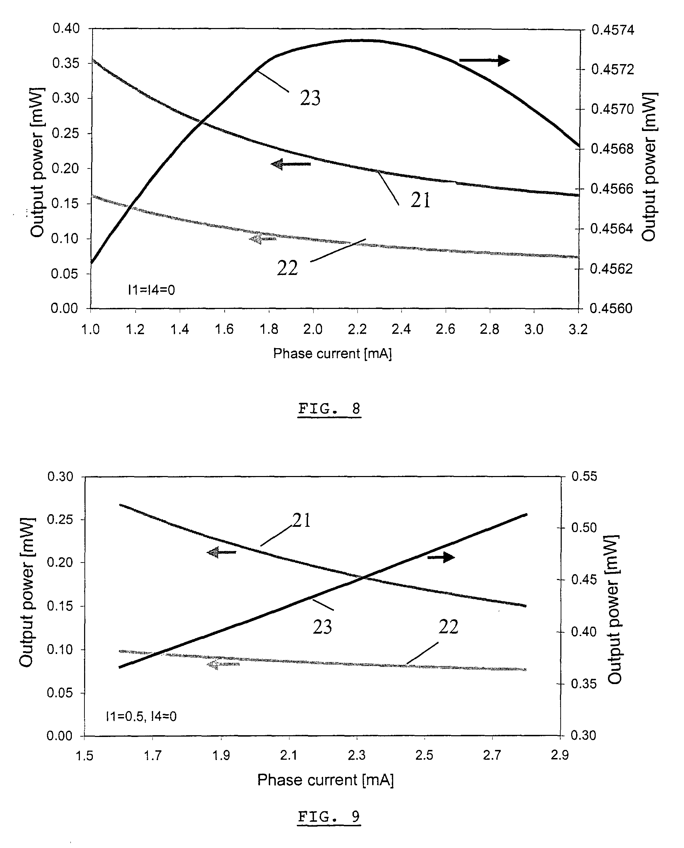

In some cases, it was found numerically that the ratio of the output powers also showed an optimum as a function of the Bragg current. This is illustrated in figure 6. Curve 16 represents the output power on the left hand side, curve 17 represents the output power on the right hand side, and curve 18 represents the ratio of the two output powers. Figure 7 shows the wavelength 19 as a function of Bragg current, for the same simulation. However, this is not a general property. It appears only for particular laser parameters. Still the output power ratio can for these situations be used as control quantity, even when the Bragg current is used for control. As a result, one can also develop control techniques based on a feedback of the output power ratio to the Bragg current and using the phase current to adjust the wavelength.

This method in principle also extends to multiple section lasers, such as 4 section GCSR laser diodes. An example of such a 4 section laser diode is shown in figure 3. Variations of the internal losses in both the phase and the coupler section should have no (or little in the case of the coupler section) influence on the output power ratio. It also wouldn't matter that the phase and Bragg section are slightly active instead of lossy, as can be seen from the formulas.

It is found that, as for a previous control method for 3-section DBR lasers, the ratio of the output powers from left and right hand side facets is again useful for control of a 4-section (S)SG-DBR laser diode. When considering the variation of this power ratio for a variation in the phase current, it is seen that the variation in power ratio is minimal when a perfect overlap between reflection peaks from both grating sections 7 exists. This is illustrated in the figures 8 and 9. Figure 8 gives the output powers (left facet and right facet, numerical references 21,22) and the ratio 23 of the output powers as a function of the phase current for a perfect overlap of the peak wavelengths from both grating sections 7. Figure 9 shows the same variation when the peak wavelengths differ by 0.5 nm. One can use the variation of the ratio of the output powers with the variation of the phase current to adjust or control the difference between the currents injected in both grating sections, i.e. $I_{SG1}$-$I_{SG2}$. To this end, the phase current can be dithered slightly and the corresponding modulation in the ratio of the output powers can be used for the control. If both reflection peaks are overlapping, they provide a sharp wavelength dependence of the mirror losses (i.e. with twice the selectivity of a single reflector).

There are then 2 possible ways to extend the control. A first possibility is to use the variation in voltage over the active layer caused by the modulation of the phase current to adjust the bias current to the phase section. The signal from a wavelength locker can then be used to control one of the two grating currents. An alternative is to use the signal from a wavelength locker to control the bias current to the phase section and use the voltage modulation to adjust one of the two grating currents.

In the above derivation, it is also assumed that there is little current leaking from the phase section to the Bragg section. Indeed, it is assumed that the functions $R_3$ and $T_3$ remain unchanged when the phase current is varied. This is no longer the case if leakage occurs. The invented method is less dependent on the internal losses and their variation with tuning currents. Indeed, the ratio of the output powers is unaffected by the losses in the phase section. And since by using this ratio to ensure the perfect overlap of two reflection peaks one obtains a very sharp optimum in voltage vs. phase current, also the control based on the voltage will be less influenced by losses.

Also in lasers with multiple passive sections as disclosed in Patent Applications EP 998701056 and EP 998702146, the same principle of loss independence or loss increase independence can be used. One can for instance on these passive sections used for control apply small modulation currents having a different frequency for the different sections. The frequency components will be observed in the quantity used for control. These different frequency components can be used each for controlling the current of the related section. The ratio of the output powers or a function thereof will still be substantially independent of the loss increases in said sections.

Note that the failure of the prior-art control techniques can be coped with by adapting the laser structure to be controlled for instance by designing a rather expensive selective reflector, which is a difficult design problem which has also some disadvantages. The prior-art control techniques thus require a laser structure for which the loss increases due to current injection is neglectable. Because the quantity used in the disclosed control method is selected to be inherently less sensitive to said loss increases, the design requirements for obtaining a laser structure being satisfactory controllable with said method are less severe.

For implementing the above disclosed control method a particular control apparatus according to the invention can be used. Said laser control apparatus can be characterised in that it contains at least two power measuring devices, a plurality of current sources and a computing device for determining current values for said current sources from power measurements being determined with said power measuring devices. Said power measuring devices can be photodiodes, potentially integrated in the laser to be controlled. Said computing device can for instance be a microprocessor. In said computer device at least means for determining a quantity being a combination of said power measurements must be foreseen. Said computing device must be adapted for optimising said quantity as function of one of said currents also. As indicated it can be used to modulate said currents, even at different frequencies, so potentially said current sources are adapted to enable this.

**Claims**

1. A method for controlling a laser structure, comprising at least an amplifying section (10), a phase section (20), a first reflection section (30), a first facet (40), emitting a substantial part of the electromagnetic radiation generated by said laser structure, and a second facet (50), a first injection means (60) for injecting current in said phase section (20), a second injection means (70) for injecting current in said reflection section (30), said method comprising the steps of:

   - determining a first value by measuring the power output at said first facet (10),
   - determining a second value by measuring the power output at said second facet (20),
   - determining a third value depending on said first value and said second value,
   - determining a plurality of values for currents for controlling said laser structure from at least said third value, wherein said determining being based on a step of optimising said third value,
   - injecting said currents with said determined current values via said injection means (60, 70).

2. The method recited in claim 1, wherein at least the current to be injected in the phase section (20) is determined from said third value.

3. The method recited in claim 2, wherein the wavelength of the electromagnetic radiation, emitted by said laser structure is controlled via the current injected via said second injection means (70) in said reflection section (30).

4. The method recited in claim 1, wherein at least the current to be injected in the reflection section (30) is determined from said third value.

5. The method recited in claim 4, wherein the wavelength of the electromagnetic radiation, emitted by said laser structure is controlled via the current injected via said first injection means (60) in said phase section (20).

6. The method recited in claim 1, wherein said dependence of said third value from said first and second value being selected such that said third value is independent from the losses in at least one of said sections.

7. The method recited in claim 1, wherein said dependence of said third value from said first and second value being selected such that said third value is substantially independent from the losses in at least one of said sections.

8. The method recited in claim 1, wherein said dependence of said third value from said first and second value being selected such that said third value is independent from the loss increases in at least one of said sections.

9. The method recited in claim 1, wherein said dependence of said third value from said first and second value being selected such that said third value is substantially independent from the loss increases in at least one of said sections.

10. The method recited in claim 1, wherein said third value being the ratio of said first value and said second value.

11. The method recited in claim 1, wherein said third value being a ratio of a function of said first value and a function of said second value.

12. The method recited in claim 1, wherein said determining of the values of said currents to be injected being based on a step of determining the maximum of said third value.

13. The method recited in claim 1 wherein said laser structure has a second reflection section and the currents being injected in said reflection sections being determined from the relation between said third value and the phase current.

14. A laser control apparatus, comprising:

- two devices, being able to measure power,
- a plurality of current sources,
- a computing device for determining current values for said current sources from the optimisation of a value derived from two power measurements being determined with said power measuring devices.

FIG. 1

Frequency or wavelength.

FIG. 2

FIG. 3

FIG. 4

FIG. 5

FIG. 6

FIG. 7

FIG. 8

FIG. 9

## EUROPEAN SEARCH REPORT

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,X | US 5 450 428 A (MAEDA MINORU) 12 September 1995 (1995-09-12) * column 3, line 1-21; figure 1 * * column 4, line 11-22 * | 1-3, 6-11,14 | H01S5/0625 H01S5/0683 |
| A | * column 5, line 1-42 * | 4,5,12, 13 | |
| D,A | PATENT ABSTRACTS OF JAPAN vol. 1999, no. 08, 30 June 1999 (1999-06-30) & JP 11 087827 A (TOSHIBA CORP), 30 March 1999 (1999-03-30) | 1,14 | |
| A | * abstract * | 1 | |
| D,A | PATENT ABSTRACTS OF JAPAN vol. 012, no. 423 (E-680), 9 November 1988 (1988-11-09) & JP 63 160391 A (TOSHIBA CORP), 4 July 1988 (1988-07-04) | 1,14 | |
| A | * abstract * | 1 | TECHNICAL FIELDS SEARCHED (Int.Cl.7) |
| A | PATENT ABSTRACTS OF JAPAN vol. 1999, no. 03, 31 March 1999 (1999-03-31) & JP 10 321938 A (NIPPON TELEGR &AMP;TELEPH CORP &LT;NTT&GT;), 4 December 1998 (1998-12-04) * abstract * | 1,14 | H01S |
| A | US 4 920 542 A (LECLERC DENIS ET AL) 24 April 1990 (1990-04-24) * the whole document * | 1,14 | |

-/--

The present search report has been drawn up for all claims

| Place of search | Date of completion of the search | Examiner |
|---|---|---|
| THE HAGUE | 7 November 2001 | Claessen, L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

**European Patent Office**

## EUROPEAN SEARCH REPORT

Application Number

EP 01 87 0155

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | GLANCE B ET AL: "ONE-THZ DIGITAL RANDOM ACCESS HIGH RESOLUTION OPTICAL FREQUENCY SYNTHESIZER PROVIDING COLD-START OPERATION FROM A FREQUENCY REFERENCE" SAN DIEGO, DEC. 2 - 5, 1990, NEW YORK, IEEE, US, vol. -, 2 December 1990 (1990-12-02), pages 766-767, XP000220883 ISBN: 0-87942-632-2 * the whole document * | 1,14 | |
| E | WO 00 54381 A (ALTITUN AB ;ANDERSSON LARS (SE); RENLUND MARKUS (SE)) 14 September 2000 (2000-09-14) * page 12, line 20-25; figures 1,2 * | 1-14 | |
| | | | TECHNICAL FIELDS SEARCHED (Int.Cl.7) |

The present search report has been drawn up for all claims

| Place of search | Date of completion of the search | Examiner |
|---|---|---|
| THE HAGUE | 7 November 2001 | Claessen, L |

EPO FORM 1503 03.82 (P04C01)

EP 1 172 905 A1

## ANNEX TO THE EUROPEAN SEARCH REPORT
## ON EUROPEAN PATENT APPLICATION NO.

EP 01 87 0155

This annex lists the patent family members relating to the patent documents cited in the above-mentioned European search report.
The members are as contained in the European Patent Office EDP file on
The European Patent Office is in no way liable for these particulars which are merely given for the purpose of information.

07-11-2001

| Patent document cited in search report | | Publication date | Patent family member(s) | | Publication date |
|---|---|---|---|---|---|
| US 5450428 | A | 12-09-1995 | JP<br>JP | 3026291 B2<br>7106708 A | 27-03-2000<br>21-04-1995 |
| JP 11087827 | A | 30-03-1999 | JP | 3167967 B2 | 21-05-2001 |
| JP 63160391 | A | 04-07-1988 | NONE | | |
| JP 10321938 | A | 04-12-1998 | NONE | | |
| US 4920542 | A | 24-04-1990 | FR<br>DE<br>DE<br>EP<br>JP<br>JP | 2639773 A1<br>68909747 D1<br>68909747 T2<br>0370443 A1<br>2188985 A<br>2776922 B2 | 01-06-1990<br>11-11-1993<br>27-01-1994<br>30-05-1990<br>25-07-1990<br>16-07-1998 |
| WO 0054381 | A | 14-09-2000 | SE<br>AU<br>AU<br>WO<br>WO<br>SE<br>SE | 514188 C2<br>3202700 A<br>3202900 A<br>0054380 A1<br>0054381 A1<br>9900536 A<br>9903039 A | 22-01-2001<br>28-09-2000<br>28-09-2000<br>14-09-2000<br>14-09-2000<br>18-08-2000<br>18-08-2000 |

EPO FORM P0459

For more details about this annex : see Official Journal of the European Patent Office, No. 12/82

15